# EUROPÄISCHE PATENTANMELDUNG

(11) **EP 1 811 057 A1**
(43) Veröffentlichungstag der Anmeldung: **25.07.2007**
(21) Anmeldenummer: 07000323.1
(22) Anmeldetag: 09.01.2007
(51) Int. Cl.: C23C 14/34

(54) **Sputtertarget mit hochschmelzender Phase**

(30) Priorität: 23.01.2006 DE 102006003279
(71) Anmelder: W.C. Heraeus GmbH, 63450 Hanau (DE)
(72) Erfinder: Schlott, Martin, Dr., 63075 Offenbach (DE); Schultheis, Markus, 36103 Flieden (DE)
(74) Vertreter: Kühn, Hans-Christian

(57) **Zusammenfassung**

Die Erfindung betrifft ein Sputtertarget aus einem mindestens zwei Phasen oder Komponenten enthaltenden Material, wobei mindestens eine Minoritätsphase in der Matrix schwer löslich ist und einen höheren Schmelzpunkt aufweist als die Matrix und besteht darin, dass die mindestens eine Minoritätsphase eine mittlere Größe ihrer Körner oder der aus ihren Körnern gebildeten Agglomerate von höchstens 10µm aufweist und das Material eine Dichte von mindestens 98% der theoretischen Dichte aufweist.

## Beschreibung

Die Erfindung betrifft ein Sputtertarget aus einem mindestens zwei Phasen oder Komponenten enthaltenden Material, wobei mindestens eine Minoritätsphase in der Matrix schwer löslich ist und einen höheren Schmelzpunkt aufweist als die Matrix.

Neben einkomponentigen Werkstoffe wie Al, Ti, Mo und Cr werden zur Herstellung von TFT-LCD Displays jüngst auch vermehrt pulvermetallurgische Mischungen sowie Legierungen mit Ausscheidungen einer zweiten Phase als sogenannte Sputtertargets eingesetzt (EP 1 559 801). Bei diesem Vakuum-Beschichtungsverfahren wurden bisher überwiegend einkomponentige Sputtertargets eingesetzt, um die entsprechenden Schichten (z.B. zur Strukturierung von Source-, Drain- und Gatekontakten oder für reflektive/teilreflektive Anwendungen) herzustellen. Soweit die zweite Phase einen hohen Schmelzpunkt und eine schlechte oder verschwindende Löslichkeit in der Majoritätskomponente aufweist verbleiben nur pulvermetallurgische Herstellmethoden für entsprechende Sputtertargets. Bevorzugte pulvermetallurgische Verfahren sind das Sintern, Sintern und anschließendes Walzen, das heißisostatische Pressen und Zersägen von großen Blöcken oder das heißisostatische Pressen und anschließende Umformen zu Platten oder Rohren.

Bei der Herstellung der TFT-Displays ist es sehr wichtig, dass die Sputtertargets keine Partikel freisetzen, da dies zu Ausfällen einzelner Bildpunkte (Pixel) führen kann. Bei mehrkomponentigen Sputtertargets mit sehr unterschiedlichem Schmelzpunkt bzw. Sputterraten besteht das Problem, dass die hochschmelzende Phase wegen der geringen Sputterrate im Vergleich zur Matrix mit hoher Sputterrate zu Erhebungen führt. Je nach Materialkombination können diese Erhebungen zu Kegeln oder Nodules anwachsen, bis sie bei einer bestimmten Größe aufgrund thermischer Spannungen oder einer kurzen Entladung (Arc) zerplatzen und Partikel freisetzen.

Aufgabe der vorliegenden Erfindung ist es daher, Sputtertargets auf der Basis verschiedener mehrkomponentiger bzw. mehrphasiger Werkstoffe, also solcher, die keine "echten" Legierungen bzw. Mischkristalle bilden, zu entwickeln (z.B. für die TFT-Display-Beschichtung), deren Gefüge so ausgebildet ist, dass sich beim Abtrag während das Sputterns möglichst keine die Produktausbeute verschlechternden Partikel bilden.

Die Aufgabe wird durch die unabhängigen Ansprüche gelöst. Vorteilhafte Ausgestaltungen ergeben sich aus den abhängigen Ansprüchen. Die Struktur der mindestens einen Minoritätsphase ist dabei durch Körner oder durch aus Körnern gebildeten Agglomerate mit einer mittleren Größe von höchsten 10µm, bevorzugt höchstens 5µm, insbesondere höchstens 1µm gekennzeichnet und das Material weist eine Dichte von mindestens 98%, vorzugsweise mindestens 99% der theoretischen Dichte auf. Als Minoritätsphase wird auch eine Minoritätskomponente, als Hauptphase auch eine Hauptkomponente bezeichnet, wobei eine Komponente ungelöste Phasenanteile bezeichnet. Die Hauptphase bzw. Hauptkomponente bildet die Matrix. Als schwer lösliche Phasen werden solche bezeichnet, deren Löslichkeit mindestens 3-5 mal geringer ist als ihr Gewichtsanteil in Bezug auf die Matrix, so dass im thermischen Gleichgewicht bei Raumtemperatur der überwiegende Teil der Phase/Komponente in Form von Ausscheidungen vorliegt. Insgesamt sollte die Löslichkeit der Minoritätsphase außerdem nicht größer als etwa 1% sein.

Die mindestens eine Minoritätsphase weist vorteilhafter Weise einen um mindestens 500°C, vorzugsweise um mindestens 1000°C höheren Schmelzpunkt auf als die Matrix. Es ist zweckmäßig, dass das Material Metalle aus der Gruppe W, Mo, Ta, Nb, Cr, V, Ti, Cu, Ni, Al, Ag, Au, Pt, Ru enthält. Vorteilhaft ist es, dass das Material auf der Basis von Cu, Ag oder Al als Matrix gebildet ist und die mindestens eine schwer lösliche Phase mindestens eines der Elemente Cr, Mo, W, Ti, Ru enthält.

Der Anteil der Komponente mindestens einer Minoritätsphase an dem Material beträgt vorzugsweise mindestens 0,5 Gew%. Der Gesamtanteil der Komponente der mindestens einen Minoritätsphase an dem Material beträgt vorzugsweise höchstens 10 Gew%.

Ein erfindungsgemäßes Verfahren zur Herstellung von Sputtertargets ist dadurch gekennzeichnet, dass aus Pulver in einem ersten Schritt ein Mischung derart hergestellt wird, dass die Minoritätskomponente(n) fein dispergiert wird, so dass bevorzugt keine oder nur noch sehr kleine Agglomerate vorliegen und die Partikel der mindestens einen Minoritätsphase eine mittlere Größe von höchsten 10µm, bevorzugt höchstens 5µm, insbesondere höchstens 1µm aufweisen. Aus dieser Pulvermischung wird dann über bekannte Herstellverfahren wie Sintern und Walzen, HIP und Sägen oder HIP und Umformung ein planares oder rohrförmiges Sputtertarget hergestellt.

Es wurde also gefunden, dass es möglich ist, die Entstehung von Nodules oder Kegeln auf dem Sputtertarget zu unterdrücken oder zumindest stark zu reduzieren, wenn man für die Minoritätsphase(n) ein "monodisperses" Pulver mit ausreichend feiner Korngröße einsetzt und die Pulvermischung anschließend auf konventionellem Wege auf > 98% Dichte verdichtet.

Damit ist es möglich, Sputtertargets mit geringer Partikelrate und hoher Dichte in Form von Platten oder Rohren auf der Basis mehrphasiger Werkstoffe, bevorzugt auf Basis von W, Mo, Ta, Nb, Cr, V, Ti, Cu, Ni, Al, Ag, Au, Pt, Ru, besonders Cu:Mo, Cu:W, Ag:Cr, Ag:Mo, Ag:W, Ag:Ti, herzustellen zur Beschichtung großformatiger Substrate z.B. für TFT-LCD Bildschirme.

Nachfolgend werden Ausführungsbeispiele der Erfindung beschrieben.
1) Eine Pulvermischung aus 99 Gew% Ag und 1 Gew% sehr feinem Cr-Pulver mit einer mittleren Korngröße von 7µm wurde in einem Flügelradmischer intensiv gemischt, so dass sich eine feine und monodisperse Verteilung der Cr-Partikel ergab. Anschließend wurde diese Mischung zunächst durch kaltisostatisches Pressen zu einem Zylinderblock mit Dₐ=300mm und L=400mm verpresst. Dieser Zylinder wurde zu einem Hohlzylinder mit Dₐ=300mm, Dᵢ=120mm bearbeitet. Der erhaltene Hohlzylinder wurde durch Strangpressen bei 500°C zu einem Rohrrohling mit Dₐ= 157mm und Dᵢ=122mm umgeformt.
   Das erhaltene Umformgefüge zeigte eine Matrix aus Ag-Körner, in die einzelne, vollständig desagglomerierte Cr-Partikel mit einer mittleren Korngröße von 7µm eingebettet waren.
   Aus dem so geformten Rohr wurde ein monlytisches (= trägerrohrloses) Targetrohr mit den Abmessungen Dₐ= 153mm, Dᵢ=124mm und L=2400mm gedreht und im Sputterbetrieb getestet. Es ergab sich ein sehr glatte Erosionszone und ein sehr partikelarmer Sputterbetrieb.
2) Eine Pulvermischung aus 97 Gew% Cu und 3 Gew% sehr feinem Mo-Pulver mit einer mittleren Korngröße von 3µm wurde in einem Flügelradmischer intensiv gemischt, so dass sich eine feine und monodisperse Verteilung der Mo-Partikel ergab. Anschließend wurde diese Mischung zunächst durch kaltisostatisches Pressen zu einem Rechteckblock mit einem Querschnitt von 50x100mm und einer Länge von L=400mm verpresst.
   Anschließend wurde der Block durch HIP bei 750°C und 1000bar zu mehr als 99% seiner theoretischen Dichte verdichtet. Das Gefüge bestand aus einer Cu-Matrix, in die einzelne, vollständig desagglomerierte Mo-Partikel mit einer mittleren Korngröße von 3µm eingebettet waren. Nur ganz vereinzelt waren auch Teilchen aus 2-3 Partikeln anzutreffen.
   Aus dem so geformten Block wurde eine Targetplatte mit 88x350mm Länge gefertigt. und im Sputterbetrieb getestet. Es ergab sich ein sehr glatte Erosionszone und ein nahezu partikelfreier Sputterbetrieb.
3) Analog Beispiel 1 und 2 mit Cu:Cr, Cu:W, Cu:Ru, Cu:Ti, Ag:Mo, Ag:W, Ag:Cr, Ag:Ti, Ag:Ru für Legierungsanteile Mo, W, Cr, Ti, Ru im Bereich von jeweils kleiner 10 Gew%.
4) Vergleichsbeispiel: Eine Pulvermischung aus 96 Gew% Cu und 4 Gew% eines W-Pulvers mit einer mittleren Korngröße von 40µm wurde analog Beispiel 2 verarbeitet. Das Gefüge bestand aus der Cu-Matrix in die einzelne W-Partikel mit typisch 40µm Größe eingebaut waren. Beim Sputtern ergab sich eine sehr raue Oberfläche die von zahllosen Kegeln/Nodules überzogen war. Nach einer gewissen Zeit (ca. 20% der Lebensdauer des Targets) begann das Target verstärkt Partikel freizusetzen, so dass es für die Beschichtung z.B. von TFT Substraten oder anderen elektronischen Schaltkreisen ungeeignet wurde.
5) Vergleichsbeispiel: Eine Pulvermischung aus 99 Gew% Ag und 1 Gew% eines stark agglomerierten Mo-Pulvers mit einer mittleren Primärpartikelgröße von 4 µm und bis zu 100µm großen Agglomeraten wurde in einem Taumelmischer gemischt. Anschließend wurde die Mischung zunächst durch kaltisostatisches Pressen zu einem quaderähnlichen Block mit 60mm x 120mm x 500mm Kantenlänge verpresst. Anschließend wurde der Block durch HIP bei 750°C und 1000bar zu mehr als 99% verdichtet. Das Gefüge bestand aus der Ag-Matrix in die Mo-Agglomerate mit einer mittleren Größe von bis zu 40 µm eingebettet waren. Ein aus diesem Block gefertigtes Target von 88x350mm Größe wurde wiederum gesputtert. Sehr schnell bildete sich eine sehr zerklüftete Erosionsfläche heraus, die von Kegeln und Nodules übersäht war und anfing, viele Partikel freizusetzen. Auch dieses Target war für die Anwendung ungeeignet.

## Patentansprüche

1. Sputtertarget aus einem mindestens zwei Phasen oder Komponenten enthaltenden Material, wobei mindestens eine Minoritätsphase in der Matrix schwer löslich ist und einen höheren Schmelzpunkt aufweist als die Matrix, **dadurch gekennzeichnet, dass** die mindestens eine Minoritätsphase eine mittlere Größe ihrer Körner oder der aus ihren Körnern gebildeten Agglomerate von höchstens 10µm aufweist und das Material eine Dichte von mindestens 98% der theoretischen Dichte aufweist.

2. Sputtertarget nach Anspruch 1, **dadurch gekennzeichnet, dass** die mittlere Größe der Körner oder Agglomerate höchstens 5µm, vorzugsweise höchstens 1 µm beträgt.

3. Sputtertarget nach Anspruch 1 oder 2, **dadurch gekennzeichnet, dass** das Material eine Dichte von mindestens 99% der theoretischen Dichte aufweist.

4. Sputtertarget nach einem der Ansprüche 1 bis 3, **dadurch gekennzeichnet, dass** die mindestens eine Minoritätsphase einen um mindestens 500°C, vorzugsweise um mindestens 1000°C höheren Schmelzpunkt aufweist als die Matrix.

5. Sputtertarget nach einem der Ansprüche 1 bis 4, **dadurch gekennzeichnet, dass** das Material Metalle aus der Gruppe W, Mo, Ta, Nb, Cr, V, Ti, Cu, Ni, Al, Ag, Au, Pt, Ru enthält.

6. Sputtertarget nach einem der Ansprüche 1 bis 5, **dadurch gekennzeichnet, dass** der Anteil der Komponente mindestens einer Minoritätsphase an dem Material mindestens 0,5 Gew% beträgt.

7. Sputtertarget nach einem der Ansprüche 1 bis 6, **dadurch gekennzeichnet, dass** der Gesamtanteil der Komponente der mindestens einen Minoritätsphase an dem Material höchstens 10 Gew% beträgt.

8. Sputtertarget nach einem der Ansprüche 1 bis 7, **dadurch gekennzeichnet, dass** das Material auf der Basis von Cu oder Ag als Matrix gebildet ist und die mindestens eine schwer lösliche Phase mindestens eines der Elemente Cr, Mo, W, Ti, Ru enthält.
